(19) Europäisches Patentamt / European Patent Office / Office européen des brevets

(11) **EP 3 295 245 B1**

(12) **EUROPÄISCHE PATENTSCHRIFT**

(45) Veröffentlichungstag und Bekanntmachung des Hinweises auf die Patenterteilung:
**23.03.2022   Patentblatt 2022/12**

(21) Anmeldenummer: **16720148.2**

(22) Anmeldetag: **04.05.2016**

(51) Internationale Patentklassifikation (IPC):
**G02F 1/21** *(2006.01)*      **H01S 5/183** *(2006.01)*

(52) Gemeinsame Patentklassifikation (CPC):
**G02F 1/21; G02F 1/218; H01S 5/18361;**
G02F 2201/346; H01S 5/18341; H01S 5/32341

(86) Internationale Anmeldenummer:
**PCT/EP2016/060009**

(87) Internationale Veröffentlichungsnummer:
**WO 2016/180705 (17.11.2016 Gazette 2016/46)**

(54) **STEUERBARER BRAGG-REFLEKTOR**

CONTROLLABLE BRAGG REFLECTOR

RÉFLECTEUR DE BRAGG RÉGLABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.05.2015   DE 102015107239**

(43) Veröffentlichungstag der Anmeldung:
**21.03.2018   Patentblatt 2018/12**

(73) Patentinhaber: **Rheinisch-Westfälische Technische Universität Hochschule (RWTH) Aachen 52062 Aachen (DE)**

(72) Erfinder:
• **WILLE, Ada**
 **52064 Aachen (DE)**
• **KALISCH, Holger**
 **41564 Kaarst (DE)**

(74) Vertreter: **Keenway Patentanwälte Neumann Heine Taruttis PartG mbB Postfach 10 33 63 40024 Düsseldorf (DE)**

(56) Entgegenhaltungen:
US-A1- 2004 028 092     US-A1- 2007 291 808
US-A1- 2010 172 390

• KUNG P ET AL: "ALXA1-XN BASED MATERIALS AND HETEROSTRUCTURES", MATERIALS RESEARCH SOCIETY SYMPOSIUM PROCEEDINGS; [MATERIALS RESEARCH SOCIETY SYMPOSIUM PROCEEDINGS], MATERIALS RESEARCH SOCIETY, PITTSBURG, PA; US, Bd. 449, 1. Januar 1997 (1997-01-01), Seiten 79-84, XP000923272, ISBN: 978-1-55899-828-5

• ZORILA A, SCHIOPU P: "Modeling Distributed Bragg Reflectors with superlattice materials for UV range", SPIE7821, ADVANCED TOPICS IN OPTOELECTRONICS, MICROELECTRONICS AND NANOTECHNOLOGIES V, Bd. 7821, 78212B, 3. Dezember 2010 (2010-12-03), Seiten 1-9, XP040550772, BELLINGHAM, USA DOI: 10.1117/12.883292

• ADA WILLE: "Strain relief mechanisms and growth behaviour of superlattice distributed Bragg reflectors", PHYSICA STATUS SOLIDI C: CURRENT TOPICS IN SOLID STATE PHYSICS, Bd. 11, 2014, Seiten 758-761, XP002759962, in der Anmeldung erwähnt

**Beschreibung**

Die Erfindung betrifft einen steuerbaren Bragg-Reflektor, insbesondere einen spannungsgesteuerten Bragg-Reflektor.

Bragg-Reflektoren, auch Bragg-Spiegel genannt, sind in der Fachliteratur auch synonym unter dem Namen Distributed-Bragg-Reflektor, kurz DBR, bekannt. Ein solcher Bragg-Reflektor besteht dabei aus mehreren, wechselweise angeordneten Schichten zweier Materialien, die unterschiedliche Brechungsindizes aufweisen. Durch einen speziellen Aufbau wird nur Licht eines bestimmten Wellenlängenbereichs um die zentrale Bragg-Wellenlänge $\lambda_0$ reflektiert. Andere Lichtwellenlängen werden nicht reflektiert. Ebenfalls existiert analog der umgekehrte Fall der Antireflexion (Transmission) in einem bestimmten Wellenlängenbereich. Bekannte Materialpaarungen für einen solchen Bragg-Reflektor können dabei Titandioxid (n≈2,5) mit Siliziumdioxid (n≈1,5) oder die Paarung Galliumarsenid mit Aluminiumarsenid oder andere Gruppe-3 Nitride wie beispielsweise Galliumnitrid mit Aluminiumnitrid sein. Die Energien der Bandlücken dieser Materialien sind in der Regel größer als die Energie des einfallenden Lichtes, so dass keine oder nur geringe Absorption der einfallenden Strahlung im Material auftritt. Die Materialien besitzen somit in der Regel in guter Näherung einen reellen Brechungsindex für die einfallende Strahlung.

Fällt Licht in diesen speziellen Schichtaufbau, d. h. parallel zu den Flächennormalen der Schichten, so wird aufgrund der unterschiedlichen Brechungsindizes der wechselweise angeordneten Schichten an jeder Grenzfläche zweier benachbarter Schichten ein Teil des einfallenden Lichts mit kontrollierter Phase reflektiert. Die optische Schichtdicke beider Schichtarten, welche möglichst exakt 1/4 der Bragg-Wellenlänge $\lambda_0$ betragen muss, berechnet sich jeweils aus dem reellen Brechungsindex $n$ und der tatsächlichen Schichtdicke $d$. Somit muss für einen Bragg-Reflektor gelten:

$$n_1 \cdot d_1 = n_2 \cdot d_2 = \lambda_0/4$$

Um also einen Bragg-Reflektor herzustellen, der Licht der Wellenlänge $\lambda_0$ reflektiert, muss in einem speziellen Fall die Schichtdicke aller Schichten $\lambda_0/4n$ betragen. Zwischen den reflektierten Anteilen zweier benachbarter Grenzflächen kommt es zu einem Phasenunterschied. Dieser setzt sich dabei aus dem Gangunterschied durch die optische Weglänge im Material und dem Phasensprung bei der Reflexion zusammen. Der Gangunterschied für direkt benachbarte Grenzflächen ist dabei zweimal eine viertel Wellenlänge, also $2 \cdot \lambda_0/4 = \lambda_0/2$, was einer Phasenverschiebung um $\pi$ entspricht. Zusätzlich kann ein Phasensprung bei der Reflexion auftreten: An der Grenzfläche der Schicht mit niedrigerem Brechungsindex (optisch dünneres Medium) zu der Schicht mit höherem Brechungsindex (optisch dichteres Medium) findet ein Phasensprung von ungefähr $\pi$ statt. An der Grenzfläche von optisch dichterem zu optisch dünnerem Medium findet kein signifikanter Phasensprung statt. Die jeweils reflektierten Lichtanteile überlagern sich somit durch den Gangunterschied und den Phasensprung immer konstruktiv. Da jedoch die Reflexion an den Schichtübergängen jeweils nur teilweise stattfindet, d.h. nur ein Teil des auf einen Schichtübergang fallenden Lichts wird reflektiert, während der übrige Anteil in die Schicht eindringt, sind mehrere Schichtübergänge notwendig, um eine nahezu vollständige Reflexion bei der Bragg-Wellenlänge zu erreichen. Die Reflektivität eines Bragg-Reflektors ist damit auf die mehreren Schichtübergänge verteilt, im Englischen ‚distributed‘; dies begründet die in der englischsprachigen Literatur gebräuchliche Bezeichnung Distributed-Bragg-Reflector (DBR).

Die gesamte Reflektivität $R$ eines Bragg-Reflektors aus mehreren Schichten lässt sich näherungsweise berechnen zu:

$$R = \left(\frac{n_0 n_2^{2N} - n_S n_1^{2N}}{n_0 n_2^{2N} + n_S n_1^{2N}}\right)^2$$

wobei $n_0$ der Brechungsindex des Mediums der Umgebung, $n_1$ und $n_2$ die Brechungsindizes der beiden Schichtmaterialien, $n_s$ der Brechungsindex des Substrats des Bragg-Reflektors und $N$ die Anzahl der Schichtpaare ist. Typischerweise erreicht ein Schichtpaket der Paarung AlGaN und GaN mit ca. 30 Schichtpaaren eine Reflektivität von nahezu 100%. Andere Materialpaarungen können die gleiche Reflektivität mit deutlich mehr oder weniger Schichtpaaren erreichen. Die oben beschriebene Geometrie des Bragg-Reflektors sowie die angegebenen Formeln gelten nur näherungsweise, insbesondere bei absorbierenden Materialien. Außerdem sind auch verstimmte Bragg-Reflektoren mit abweichenden Schichtdicken möglich, wobei das zu Grunde liegende Funktionsprinzip hiervon unberührt bleibt.

Als Stoppband wird der Wellenlängenbereich bezeichnet, für den die Reflexion besonders hoch ist. Die Breite des Stoppbands um die reflektierte Bragg-Wellenlänge $\lambda_0$ berechnet sich näherungsweise zu:

$$\Delta\lambda_0 = \frac{4 \cdot \lambda_0}{\pi} \arcsin\left|\frac{n_1 - n_2}{n_1 + n_2}\right|$$

Bragg-Reflektoren können zum Beispiel in Halbleiterlasern wie beispielsweise Oberflächenemittern, sogenannten Vertical Cavity Surface Emitting Lasers (VCSELs) oder auch anderen Lasern eingesetzt werden. Dabei werden die Bragg-Reflektoren als Spiegel verwendet, da die Wellenlänge des zu reflektierenden Lichts genau festgelegt ist und der Spiegel nicht reflektierte Anteile verlustarm transmittiert. Zwei gegenüber angeordnete Spiegel, d.h. zwei gegenüber angeordnete Bragg-Reflektoren, bilden dabei einen wellenlängenselektiven Resonator für ein zwischen den beiden Bragg-Reflektoren angeordnetes aktives, lichterzeugendes Medium. Bei einem VCSEL werden dabei die einzelnen Schichten übereinander auf einem Substrat abgeschieden, wobei im Wesentlichen zunächst die Schichten eines ersten Bragg-Reflektors abgeschieden werden, darauf dann das aktive Medium, welches das Licht erzeugt, und darauf schließlich die Schichten des zweiten Bragg-Reflektors. Unter der Annahme, dass die Oberfläche des Substrats beim Abscheiden der verschiedenen Schichten horizontal angeordnet ist, entsteht auf diese Weise eine vertikale Struktur, eben ein sogenanntes VCSEL. Ein Bragg-Reflektor kann aber auch beispielsweise als diskretes optisches Element eingesetzt werden, z. B. zur wellenlängenselektiven Reflexion in Projektionssystemen oder Gaslasern.

Herkömmliche Bragg-Reflektoren sind dabei typischerweise statisch, d.h. die Reflektivität ist nicht veränderbar, da Eigenschaften der Schichtanordnung eines Bragg-Reflektors typischerweise durch die Materialauswahl und die Geometrie festgelegt sind.

Die US 2007/0291808 A1 beschreibt einen Mehrschicht-Interferenzreflektor, dessen Stoppband-Wellenlänge durch eine angelegte Spannung eingestellt werden kann. Das Einstellen des Mehrschicht-Interferenzreflektors wird dabei elektro-optisch mittels des Stark-Effekts erreicht, d.h. die von dem Mehrschicht-Interferenzreflektor durchgelassene Wellenlänge ist einstellbar. Jedoch offenbart diese Schrift nicht den Aufbau eines Übergitters, an dessen Grenzschichten sich Elektronen- oder Löchergase ausbilden und dass die Reflektivität des Reflektors durch Steuerung der Elektronen- bzw. Löchergase stattfindet.

Aus der Veröffentlichung "Strain relief mechanisms and growth behaviour of superlattice distributed Bragg reflectors" von Ada Wille, veröffentlicht 2014 in Physica Status Solidi C: Current Topics in Solid State Physics Vol. 11 Seiten 758-761, ist die Herstellung von Nitrid-DBR unter Verwendung eines Übergitters für die ¼-Lambda-Schicht mit niedrigem Brechungsindex bekannt. Jedoch liefert diese Schrift keinen Hinweis auf eine Steuerung in dem DBR mittels Steuerung eines Elektronen- oder Löchergases. Vielmehr ist die dort gezeigte Struktur für die Herstellung eines steuerbaren DBR ungeeignet.

Die Veröffentlichung "A novel vertical-cavity surface-emitting laser with semiconductor/superlattice distributed bragg reflectors von Yan-Kuin Su et al, IEEE Photonics Technology Letters, Vol. 14, 2002, No 10, Seiten 1388-1390, beschreibt einen DBR mit einem Übergitter, wobei die Reflektivität des Übergitters jedoch nicht steuerbar ist.

Die US 2009/0 041 464 beschreibt einen elektro-optischen Modulator, der auf einem lichtemittierenden Element abgeschieden ist, welcher gemäß dem Franz-Keldysh, Kerr-oder (Anti-)Stark Effekt basiert. Diese Schrift offenbart jedoch nicht die Steuerung der Reflektivität des Übergitters durch Steuerung von Elektronen- oder Löchergasen, die zwischen den Schichten des Übergitters entstehen.

Die Emissionswellenlänge herkömmlicher VCSELs wird durch die gewählten Materialien des aktiven Mediums und ihre Geometrie festgelegt. Die Bragg-Reflektoren müssen dann eine Bragg-Wellenlänge $\lambda_0$ gleich der Emissionswellenlänge des aktiven Mediums aufweisen. Die verwendete Materialpaarung für die Bragg-Reflektoren sowie die einzelnen Schichtdicken werden somit spezifisch für das aktive Medium ausgewählt.

Die vorliegende Erfindung betrifft einen steuerbaren Bragg-Reflektor mit einer mehrschichtigen Struktur und einer abwechselnden Schichtreihenfolge eines Werkstoffs mit einem Übergitter und einem Gruppe-3-Nitrid-Material mit jeweils unterschiedlichem Brechungsindex. Das besagte Übergitter bildet eine Pseudolegierung aus Gruppe-3-Nitrid-Materialien. Bragg-Reflektoren nach der vorliegenden Erfindung sind besonders zur Reflexion von Wellenlängen im Bereich von 300 nm bis 500 nm geeignet. Zudem kann die Stoppband-Wellenlänge der erfindungsgemäßen Bragg-Reflektoren gezielt verändert werden bzw. die Reflexion bei der Stoppband-Wellenlänge kann gesteuert werden.

KURZE FIGURENBESCHREIBUNG

Nachfolgend wird die Erfindung näher anhand von Figuren erläutert, dabei zeigen

Fig. 1    eine schematische Darstellung einer Schichtanordnung eines steuerbaren Bragg-Reflektors;

Fig. 2    eine schematische Darstellung einer Pseudolegierung.

BSCHREIBUNG DER ERFINDUNG

Der nachfolgend näher beschriebene Bragg-Reflektor kann in seiner Reflektivitätscharakteristik durch Anlegen einer Spannung verändert werden. Dazu werden die speziellen Eigenschaften eines Materials mit Übergitter ausgenutzt, welche eine spannungsabhängige Steuerung der komplexen dielektrischen Eigenschaften (optische Dichte und optische Absorption) einzelner Schichten erlauben. Tritt Absorption auf, wird der reelle Brechungsindex *n* komplex. Es gilt dabei $n = n - ik$, wobei *k* der Extinktionskoeffizient ist.

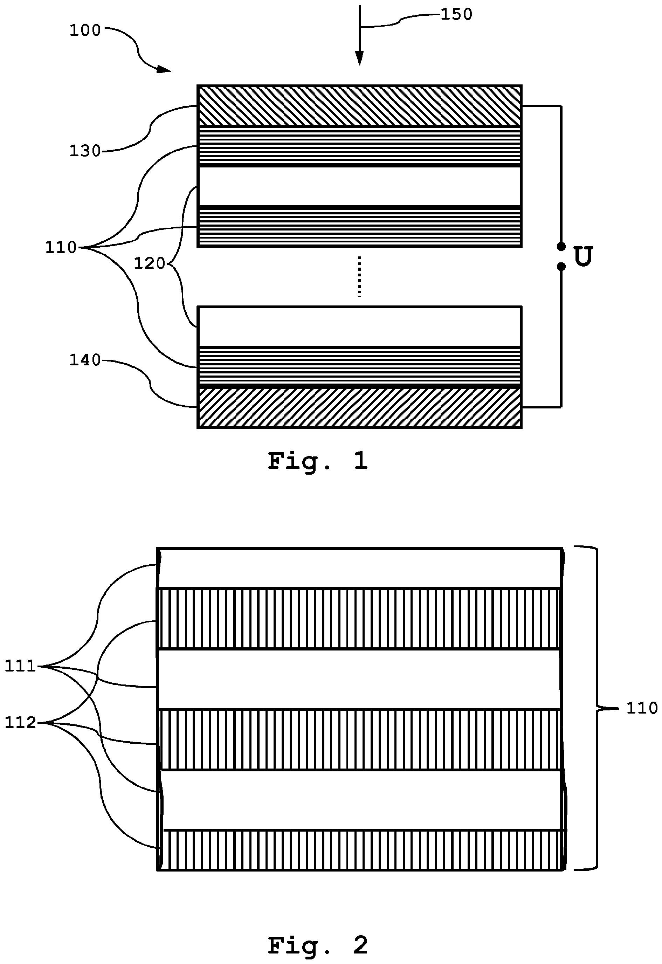

Figur 1 zeigt eine schematische Darstellung eines Bragg-Reflektors 100. Eine Schichtanordnung des Bragg-Reflektors 100 kann dabei aus mehreren wechselweise angeordneten Schichten zweier optisch verschiedener Materialien bestehen. Dabei können Schichten des ersten optischen Materials durch ein Übergitter 110 aus zwei Halbleitermaterialien gebildet sein, was eine Pseudolegierung dieser beiden Materialien darstellen kann. Schichten des zweiten optischen Materials können ein reines Halbleitermaterial 120 sein.

Das Übergitter 110 kann von einer Gruppe-3-Nitrid-Pseudolegierung ausgebildet werden und kann aus mindestens 2 oder mehr wiederum wechselweise angeordneten Schichten aus einem ersten Gruppe-3-Nitrid 111 und einem zweiten Gruppe-3-Nitrid 112 bestehen.

Gruppe-3-Nitride sind Verbindungen der Art XY wobei X für die Elemente Gallium (Ga), Aluminium (Al), Indium (In) und Bor (B) oder eine Kombination aus zwei oder mehreren dieser Elemente steht und wobei Y für das Element Stickstoff (N) oder eine Kombination der Elemente Stickstoff (N) und Phosphor (P) und/oder Arsen (As) und/oder Antimon (Sb) steht wobei solche Kombinationen hauptsächlich aus Stickstoff (N) und nur in geringen Mengen aus Phosphor (P), Arsen (As) und/oder Antimon (Sb) bestehen, so dass sich die Kristallstruktur gegenüber der Verbindung ohne Phosphor (P), Arsen (As) und/oder Antimon (Sb) nicht grundlegend ändert. Letzgenannte Verbindungen werden auch mit dem englischen Begriff "diluted nitrides" bezeichnet.

Die einzelnen Schichten des Bragg-Reflektors 100 können ausgehend von einem Substrat schichtweise abgeschieden werden. Dazu kann beispielsweise metallorganische Gasphasenepitaxie, im englischen Sprachgebrauch unter "Metal Organic Vapor Phase Epitaxy", kurz MOVPE, bekannt, genutzt werden. Dabei wachsen die einzelnen Schichten kristallin durch Bedampfen mit sogenannten Präkursoren (Vorläufer) in kontrollierten Konzentrationen für das jeweils gewünschte Schichtmaterial unter gleichzeitiger Applikation einer gewissen Temperatur und eines gewissen Drucks auf die jeweils vorherige Schicht auf. Die jeweils verschiedenen Präkursoren für die jeweilige Schicht und ein Trägergas werden in eine Reaktorkammer geleitet. Ein Schichtwachstum wird über gezielte Zuleitung der jeweiligen Präkursoren gesteuert. Somit kann entsprechend der schichtweisen Wachstumsrichtung von einer untersten Schicht und einer obersten Schicht, welche die zuletzt aufgewachsene Schicht ist, gesprochen werden.

In einer Ausführungsform können Saphir-Substrate mit einer kristallographischen (0001)-Oberfläche als Substrat für die MOVPE dienen. Als Präkursoren für AlN, GaN und AlGaN können Trimethylgallium (TMGa), Trimethylaluminium ($TMAl$) und Ammoniak ($NH_3$) verwendet werden. Die Präkursoren können mit Wasserstoff ($H_2$) oder Stickstoff ($N_2$) als Trägergas in eine Reaktorkammer geleitet werden. Nach einer Aluminiumnitrid-(AlN)-Nukleation und einer Aluminiumnitrid-(AlN)-Pufferschicht oder einer Galliumnitrid-(GaN)-Nukleation kann eine Galliumnitrid-(GaN)-Pufferschicht abgeschieden werden. Auf diese Struktur kann im Anschluss wechselweise eine Übergitterstruktur 110 aus einer Aluminium-Gallium-Nitrid-(AlGaN)-Pseudolegierung und eine Halbleitermaterialstruktur 120 aus Galliumnitrid (GaN) abgeschieden werden. Das Schichtwachstum findet dabei beispielsweise bei einer Temperatur von 1060 °C und einem Druck von 75 mbar im Reaktor statt, wobei für jedes Material abweichende Temperaturen und Drücke zum Einsatz kommen können.

In einer Ausführungsform der vorliegenden Erfindung kann die Gruppe-3-Nitrid-Pseudolegierung 110 eine Aluminium-Gallium-Nitrid-(AlGaN)-Pseudolegierung sein, wobei das erste Gruppe-3-Nitrid 111 Aluminiumnitrid (AlN) und das zweite Gruppe-3-Nitrid 112 Galliumnitrid (GaN) ist. Die Aluminiumnitrid-(AlN)-Schichten 111 und die Galliumnitrid-(GaN)-Schichten 112 können ein Dicke im Bereich von 0,1 bis 10 nm aufweisen. Die verschiedenen Schichten 111/112 des Übergitters 110 können jeweils über ihre gesamte Fläche gleichmäßig dick sein. An bestimmten Grenzflächen zwischen der Schicht des ersten Gruppe-3-Nitrids 111 und der Schicht des zweiten Gruppe-3-Nitrids 112 bilden sich zweidimensionale Elektronengase (2DEG) aus. Die Ausbildung der 2DEG hängt mit Sprüngen der elektrischen Polarisation der Gruppe-3-Nitride an den Grenzflächen zusammen und ist von der Orientierung der Kristallstruktur, den Zusammensetzungen und der Verspannung abhängig. Insofern treten 2DEG spezifisch an Übergängen von einem Material A auf ein anderes Material B auf (bezogen auf die schichtweise Wachstumsrichtung) und beispielsweise nicht beim Übergang vom Material B auf Material A (ebenfalls bezogen auf die schichtweise Wachstumsrichtung).

Bei abweichender Schichtung / Kristallorientierung ist analog auch die Ausbildung von zweidimensionalen Löchergasen möglich. So kann in einer Anordnung von drei Schichten, die unten eine Schicht Galliumnitrid (GaN), darüber eine Schicht Alumiumnitrid (AlN) und als oberste Schicht wieder Galliumnitrid aufweist, an der Oberseite der unteren Galliumnitridschicht ein zweidimensionales Elektronengas und an der Unterseite der oberen Schicht Gallimunitrid ein zweidimensionales Löchergas entstehen.

In einer bevorzugten Ausführungsform der vorliegenden Erfindung kann das Halbleitermaterial 120 Galliumnitrid (GaN) sein.

Die Schichtanordnung des Bragg-Reflektors 100 umfasst mindestens 2 wechselweise angeordnete Schichten von Übergitter 110 und Halbleitermaterial 120. Die Schichten aus Übergitter 110 können eine Schichtdicke $d_1$ und die Schichten aus Halbleitermaterial 120 können eine Schichtdicke $d_2$ haben.

Sowohl die Übergitterschichten 110 als auch die Halbleitermaterialschichten 120 können eine optische Dicke aufweisen, die ein Viertel einer Bragg-Wellenlänge $\lambda_0$ beträgt. Die optische Dicke der Schichten lässt sich aus dem jeweiligen Brechungsindex und der jeweiligen Schichtdicke berechnen:

$$n_1 \cdot d_1 = n_2 \cdot d_2 = \lambda_0/4$$

Wird die Bragg-Wellenlänge $\lambda_0$ festgelegt, können die benötigten Schichtdicken $d_1$ und $d_2$ der einzelnen Schichten der Schichtanordnung berechnet werden.

Durch das Auftreten imaginärer Anteile des komplexen Brechungsindex auf Grund von Absorption und von Resonanzen sowie von 0 und $\pi$ unterschiedlichen Phasensprüngen können die tatsächlichen Schichtdicken im Bragg-Reflektor 100 signifikant von den näherungsweise berechneten Werten abweichen, ohne Änderung des zu Grunde liegenden Funktionsprinzips. Der resultierende Bragg-Reflektor 100 ist dann zur Reflexion von Licht mit einer Wellenlänge gleich der Bragg-Wellenlänge $\lambda_0$ besonders geeignet. Die Schichtdicken innerhalb der Gruppe-3-Nitrid-Pseudolegierung sind wesentlich kleiner als ein Viertel der Bragg-Wellenlänge $\lambda_0$. Somit wird das einfallende Licht nicht an Grenzflächen innerhalb der Übergitterschicht 110, sondern nur an den Grenzflächen zwischen einer Übergitterschicht 110 und einer Halbleitermaterialschicht 120 reflektiert.

Licht einer Wellenlänge gleich der Bragg-Wellenlänge $\lambda_0$ wird von dem Bragg-Reflektor 100 nahezu vollständig reflektiert. Je mehr Schichten der Bragg-Reflektor 100 aufweist, desto mehr Licht kann reflektiert werden, wobei sich die Reflektivität des Bragg-Reflektors mit zunehmender Anzahl an Paaren asymptotisch an 100 % annähert. Einfallende Lichtwellen werden an den Phasengrenzen zwischen den Schichten aus Übergitter 110 und Halbleitermaterial 120 und vice versa reflektiert. Dabei beträgt die Phasenverschiebung immer ein ungerades Vielfaches von $\pi$. Daher addieren sich die Amplituden der reflektierten Lichtwellen bei Überlagerung auf, so dass das reflektierte Licht nahezu die gleiche Intensität besitzt wie das einfallende Licht.

Der oben beschriebene Bragg-Reflektor 100 hat ein Stoppband $\Delta\lambda_0$ um die Bragg-Wellenlänge $\lambda_0$. Licht einer Wellenlänge, welche innerhalb dieses Stoppbands $\Delta\lambda_0$ liegt, kann von dem Bragg-Reflektor ebenfalls nahezu vollständig reflektiert werden. Das Stoppband des Bragg-Reflektors 100 berechnet sich näherungsweise über:

$$\Delta\lambda_0 = \frac{4 \cdot \lambda_0}{\pi} \arcsin \left| \frac{n_1 - n_2}{n_1 + n_2} \right|$$

Der Bragg-Reflektor 100 umfasst mindestens eine erste Elektrode 130. Diese erste Elektrode kann transparent sein, wobei transparent sich hier auf die zur reflektierende Wellenlänge bezieht. Alternativ dazu kann die erste Elektrode aus nicht-transparentem Material bestehen, welches in einer geeigneten Struktur aufgebracht wird (z.B. Gitterstruktur oder ringförmige Anordnung), um den Lichteinfall zu ermöglichen. Die erste Elektrode 130 kann ein leitendes Oxid, z.B. Indium-Zinn-Oxid (ITO) oder ein leitendes Polymer oder ein sehr dünner semitransparenter Metallfilm (Schottky-Kontakt) oder ein Metallfilm (Schottky-Kontakt) oder ein p- oder n-Halbleiter sein. Die erste Elektrode 130 kann auf der obersten Schicht der Schichtanordnung des Bragg-Reflektors 100 angeordnet sein, wobei sich die Elektrode über die gesamte Fläche der Schichtanordnung, d. h.

über die gesamte obere Fläche der obersten Schicht der Schichtanordnung 100 erstreckt oder über Teilflächen der obersten Schicht der Schichtanordnung. Insbesondere kann bei Metallkontakten eine Verstärkungsschicht aufgebracht werden, um eine mechanisch stabile Kontaktierung sicher zu stellen.

Der Bragg-Reflektor 100 weist mindestens eine zweite Elektrode 140 auf. Die zweite Elektrode 140 kann ein leitendes Oxid, z.B. ITO oder ein leitendes Polymer oder ein Metallfilm oder ein p- oder n-Halbleiter sein. Die zweite Elektrode 140 kann sich über die unterste oder eine andere Schicht der Schichtanordnung des Bragg-Reflektors 100 erstrecken, wobei sich die Elektrode über die gesamte Fläche, insbesondere die Unterseite der untersten Schicht der Schichtanordnung 100 erstrecken kann. Wie oben bereits erwähnt kann insbesondere bei Elektroden aus einem Metall eine Verstärkungsteilschicht aufgebracht werden, um eine mechanisch stabile Verbindung herzustellen. Die elektrische Kontaktierung der Elektroden 130 und 140, d.h. der Anschluss an eine Spannungsquelle, kann seitlich durch Entfernen von darüber liegenden Schichten und außerhalb des aktiven Bereichs des Bragg-Reflektors erfolgen.

Die Elektroden des Bragg-Reflektors 100 können in einer alternativen Ausführungsform zwischen den Schichten aus Übergitter 110 und Halbleitermaterial 120 angeordnet sein. Dabei können die erste Elektrode 130 und/oder die zweite Elektrode 140 zwischen zwei Schichten aus Übergitter 110 und Halbleitermaterial 120 zur Kontaktierung des Bragg-Reflektors 100 angeordnet sein. Die erste Elektrode 130 und die zweite Elektrode 140 steuern in diesem Fall nur diejenigen Schichten des Bragg-Reflektors 100, die zwischen besagten Elektroden angeordnet sind. Die elektrische Kontaktierung der Elektroden kann dabei an einer Seite des Stapels des Bragg-Reflektors erfolgen.

In einer Ausführungsform der vorliegenden Erfindung kann die oberste Schicht der Schichtanordnung des Bragg-Reflektors 100 eine Schicht des Übergitters 110 sein, welche auf ihrer Oberseite von der ersten Elektrode 130 bedeckt sein kann.

In einer Ausführungsform der vorliegenden Erfindung kann die unterste Schicht der Schichtanordnung eine Schicht des Übergitters 110 sein, welche auf ihrer gesamten Unterseitenfläche von der zweiten Elektrode 140 bedeckt sein kann.

Der Bragg-Reflektor 100 kann einen Teil einer optischen Kavität parallel zu der Wachstumsrichtung der Schichtanordnung des Bragg-Reflektors 100 ausbilden. Licht 150, welches parallel zu der Wachstumsrichtung in den Bragg-Reflektor 100 einfällt, kann anteilig an Phasengrenzen zwischen den einzelnen Schichten aus Übergitter 110 und Halbleitermaterial 120 reflektiert werden. Eine konstruktive Überlagerung der reflektierten Anteile kann nur erfolgen, wenn die Wellenlänge des einfallenden Lichts 150 gleich der Bragg-Wellenlänge ist oder zumindest in dem Stoppband $\Delta\lambda_0$ des Bragg-Reflektors 100 um die Bragg-Wellenlänge $\lambda_0$ liegt.

Das einfallende Licht 150 kann teilweise durch die oberste oder mindestens eine transparente Elektrode 130 einfallen. Es ist aber auch möglich, dass das Licht 150 ausschließlich durch die oberste oder mindestens eine transparente Elektrode 130 einfällt.

In einer Ausführungsform kann das einfallende Licht 150 eine definierte Wellenlänge im Bereich von 300 nm bis 500 nm haben.

An den Bragg-Reflektor 100 kann über die erste Elektrode 130 und die zweite Elektrode 140 eine elektrische Spannung $U$ angelegt und dadurch ein elektrisches Feld erzeugt werden. Durch Steuerung des elektrischen Felds kann die Ausbildung von zweidimensionalen Elektronengasen zwischen den Schichten des Übergitters 110 gesteuert werden, d. h. die Ladungsträgerdichte in den Elektronengasen wird durch das elektrische Feld beeinflusst und somit gesteuert. Wird ein elektrisches Feld an die Schichtanordnung angelegt, so werden die Elektronengase in dem Übergitter 110 an Elektronen verarmt oder angereichert. Die Steuerung kann schnell und verlustfrei (bis auf kapazitive Verluste) erfolgen.

Es können Spannungen von bis zu ± 500 V an den steuerbaren Bragg-Reflektor 100 angelegt werden. Vorzugsweise liegt die angelegte Spannung im Bereich von -10 V bis +10 V.

In einer Ausführungsform erzeugt die angelegte Spannung $U$ innerhalb des Schichtaufbaus des Bragg-Reflektors 100 ein nahezu homogenes elektrisches Feld, dessen Feldlinien durch die Schichten aus Übergitter 110 und Halbleitermaterial 120 verlaufen. Nur in der Nähe der Randbereiche ist das elektrische Feld nicht homogen. Dies trifft vor allem bei Elektroden 130, 140 zu, welche sich über die gesamte Fläche der jeweiligen obersten und untersten Schicht der Schichtanordnung des Bragg-Reflektors 100 erstrecken können.

Durch das elektrische Feld können die zweidimensionalen Elektronengase an Elektronen verarmt oder angereichert werden. Die Übergitter 110 enthalten dadurch mehr oder auch weniger Elektronen in den zweidimensionalen Elektronengasen als im spannungslosen Zustand. Dies führt zu einer Änderung des komplexen Brechungsindex eines oder mehrerer der Übergitter 110 in dem steuerbaren Bragg-Reflektor 100. Der Bragg-Reflektor 100 wird dadurch verstimmt und einfallendes Licht 150 mit einer Wellenlänge gleich der Bragg-Wellenlänge $\lambda_0$ wird nicht mehr reflektiert. Durch die Elektronenverarmung bzw. -anreicherung und die damit verbundene Veränderung des Brechungsindex kann außerdem das Stoppband des steuerbaren Bragg-Reflektors 100 verändert werden. Solch eine spannungsgesteuerte Manipulation der zweidimensionalen Elektronengase in den Übergittern 110 kann den Reflektivitätswert des Bragg-Reflektors 100 sogar bis in eine Anti-Reflektion treiben. Bei Anti-Reflektion löschen sich die reflektierten Lichtwellen durch destruktive Interferenz gegenseitig aus, sodass der Bragg-Reflektor nicht mehr reflektiert.

In einer Ausführungsform kann einfallendes Licht 150 einer definierten Wellenlänge $\lambda_1$ ohne anlie-gende Spannung $U$ aufgrund der Elektronen der inhärenten zweidimensionalen Elektronengase der Übergitterschichten 110 und der daraus resultierenden Reflektivität des Bragg-Reflektors 100 reflektiert werden.

In einer weiteren Ausführungsform kann einfallendes Licht 150 einer anderen definierten Wellenlänge $\lambda_2$ bei anliegender Spannung U aufgrund der verarmten oder angereicherten Elektronen der zweidimensionalen Elektronengase der Übergitterschichten 110 und der dadurch veränderten Reflektivität des Bragg-Reflektors 100 mit abweichendem Reflexionsgrad reflektiert werden.

Somit kann ein spannungsgesteuerter Bragg-Reflektor z. B. zur Modulation eines optischen Signals in der Kommunikationstechnik verwendet werden. Die Intensität eines Lasers kann mit Hilfe eines erfindungsgemäßen steuerbaren Bragg-Reflektors 100 moduliert werden, indem durch spannungsgesteuerte Verstimmung der optischen Dicke eines oder mehrerer der Übergitter 110 die Güte der optischen Kavität je nach angelegter Spannung $U$ verändert werden kann. Ebenfalls kann durch den spannungsgesteuerten Bragg-Reflektor ein Ein- und Ausschalten eines Lasers erfolgen, wenn durch die spannungsgesteuerte Verstimmung der optischen Dicke eines oder mehrerer der Übergitter die Güte der optischen Kavität soweit absinkt, dass die Laserschwelle unterschritten wird. Auf diese Weise kann ein Laser moduliert werden.

Der zuvor beschriebene Schichtaufbau des Bragg-Reflektors 100 kann auch genau umgekehrt erfolgen, so dass die transparente Elektrode 130 die unterste Schicht des Bragg-Reflektors 100 bildet und das Licht 150 durch eben diese einfällt. Die zuvor beschriebenen Eigenschaften gelten analog für besagten umgekehrten Schichtaufbau.

Figur 2 zeigt einen Ausschnitt einer Schichtanordnung aus einem Übergitter 110 einer Ausführungsform der vorliegenden Erfindung. Im Übergitter 110 sind mindestens eine Schicht aus einem ersten Gruppe-3-Nitrid, hier Aluminiumnitrid (*AlN*) 111, und mindestens eine Schicht aus einem zweiten Gruppe-3-Nitrid, hier Galliumnitrid (*GaN*) 112, wechselweise angeordnet. Eine solche schichtweise Anordnung bildet eine Gruppe-3-Nitrid-Pseudolegierung, hier eine Aluminium-Gallium-Nitrid-(*AlGaN*)-Pseudolegierung

In einer Ausführungsform der vorliegenden Erfindung, kann eine oberste und eine unterste der Schichten des Übergitters 110 eine Schicht aus einem von der Schicht Halbleitermaterial 120 verschiedenen Gruppe-3-Nitrid sein. Dadurch wird ein optischer Kontrast zwischen der Schicht aus Übergitter 110 und der vorhergehenden und der nachfolgenden Halbleitermaterialschicht 120 generiert.

In einer weiteren Ausführungsform der vorliegenden Erfindung kann eine oberste und eine unterste der Schichten des Übergitters 110 eine Aluminiumnitrid (*AlN*) Schicht 111 sein. Dadurch wird ein optischer Kontrast zwischen dem Übergitter 110 und der vorhergehenden und der nachfolgenden Halbleitermaterialschicht 120 aus Galliumnitrid (GaN) generiert. Die äußeren Schichten eines Übergitters 110 sind somit jeweils eine Aluminiumnitridschicht.

In einer weiteren Ausführungsform können mehrere Bragg-Reflektoren 100 nebeneinander in einer Zeile oder einer Matrix angeordnet werden. Durch selektives Anlegen einer jeweiligen Spannung *U* kann die jeweilige Reflektivität der einzelnen parallelen Bragg-Reflektoren 100 gesteuert werden, sodass damit z. B. Displaystrukturen von Bragg-Reflektoren aufgebaut werden können.

In einer weiteren Ausführungsform der vorliegenden Erfindung kann ein steuerbarer Bragg-Reflektor ein Stapel aus zumindest zwei in Ausbreitungsrichtung des Lichts hintereinander geschalteten erfindungsgemäßen Bragg-Reflektoren 100 sein. Dabei kann jeder der seriellen Bragg-Reflektoren 100 von seinen Nachbarn durch nur eine einzige Elektrode getrennt sein. Somit können in einem steuerbaren Bragg-Reflektor-Stapel die zweite Elektrode 140 eines Bragg-Reflektors 100 und die erste Elektrode 130 eines direkt darauffolgenden Bragg-Reflektors 100 zusammenfallen. Ebenso können die erste Elektrode 130 eines Bragg-Reflektors 100 und die zweite Elektrode 140 eines direkt davorliegenden Bragg-Reflektors 100 zusammenfallen. Insbesondere kann bei dieser Ausführungsform der in Anti-Reflexion betriebene, steuerbare Bragg-Reflektor verwendet werden. In der Anti-Reflexion ist der Transmissionsgrad in der Regel größer als der Reflexionsgrad. Mit einem solchen steuerbaren Bragg-Reflektor kann dann die einfallende Lichtmenge auf ein darunterliegendes optisches Element moduliert werden.

Durch solch einen steuerbaren Bragg-Reflektor-Stapel kann die Reflektivität des Bragg-Reflektor-Stapels, also für jeden Bragg-Reflektor 100 separat, eingestellt werden. Eine solche Anordnung von mindestens zwei steuerbaren Bragg-Reflektoren erlaubt das Herausfiltern bestimmter Wellenlängen durch Anlegen eines jeweiligen elektrischen Feldes an die Bragg-Reflektoren, welche die Stoppbänder der Bragg-Reflektoren in bestimmte Wellenlängenbereiche verschieben bzw. die Reflexionsgrade für bestimmte Wellenlängen gezielt verändern. Solch eine mit dem Ort variierende Reflektivität kann beispielsweise bei Filterverfahren verwendet werden.

**Patentansprüche**

1. Steuerbarer Bragg-Reflektor (100) zur Reflexion einfallenden Lichts (150) umfassend:

   - mindestens eine Schicht eines Übergitters (110), wobei das Übergitter (110) mindestens eine Schicht aus einem ersten Gruppe-3-Nitrid (111) und mindestens eine zweite Schicht aus einem zweiten Gruppe-3-Nitrid (112) umfasst, wobei sich an mindestens einer Grenzfläche innerhalb des Übergitters (110) zweidimensionale Elektronen- oder Löchergase ausbilden,
   - mindestens eine Schicht eines Halbleitermaterials (120) und
   - mindestens zwei Elektroden (130, 140), wobei mindestens eine Elektrode (130) lichtdurchlässig für das einfallende Licht ist und das einfallende Licht (150) wenigstens teilweise durch die mindestens eine Elektrode (130) einfällt und wobei die mindestens eine Schicht eines Übergitters (110) zwischen besagten Elektroden (130, 140) angeordnet und zwischen den besagten Elektroden (130, 140) eine Spannung (*U*) anlegbar ist.

2. Steuerbarer Bragg-Reflektor 100 nach Anspruch 1, wobei das erste Gruppe-3-Nitrid (111) Aluminiumnitrid (*AlN*) und das zweite Gruppe-3-Nitrid (112) Galliumnitrid (GaN) ist.

3. Steuerbarer Bragg-Reflektor (100) nach einem der vorherigen Ansprüche, wobei das Halbleitermaterial (120) Galliumnitrid (GaN) ist.

4. Steuerbarer Bragg-Reflektor (100) nach einem der vorherigen Ansprüche, wobei die mindestens eine transparente Elektrode (130) auf der Oberfläche der obersten Schicht des Bragg-Reflektors (100) angeordnet ist.

5. Steuerbarer Bragg-Reflektor (100) nach einem der vorherigen Ansprüche, wobei die mindestens eine transparente Elektrode (130) auf der Unterseite der untersten Schicht des Bragg-Reflektors (100) angeordnet ist.

6. Steuerbarer Bragg-Reflektor (100) nach einem der vorherigen Ansprüche, wobei die mindestens eine transparente Elektrode (130) zwischen zwei Schichten des Übergitters des Bragg-Reflektors (100) angeordnet ist.

7. Steuerbarer Bragg-Reflektor (100) nach einem der vorherigen Ansprüche, wobei das einfallende Licht (150) ausschließlich durch die mindestens eine transparente Elektrode (130) einfällt.

8. Steuerbarer Bragg-Reflektor (100) nach einem der vorherigen Ansprüche, wobei die erste Elektrode (130) ein leitendes Oxid, ein leitendes Polymer, ein semitransparenter Metallfilm oder ein hochdotierter p- oder n-Halbleiter ist und wobei die zweite Elektrode (140) ein leitendes Oxid, ein leitendes Polymer, ein Metallfilm oder ein hochdotierter p- oder n-Halbleiter ist.

9. Steuerbarer Bragg-Reflektor (100) nach einem der vorherigen Ansprüche, wobei die erste Elektrode (130) aus einem nicht-transparenten Material gebildet ist und eine Struktur aufweist, die zumindest teilweisen Lichteinfall in die Halbleiter- und Übergitterschichten zulässt.

10. Steuerbarer Bragg-Reflektor (100) nach einem der vorherigen Ansprüche, wobei die erste Elektrode (130) sich über die Oberseite des Übergitters erstreckt.

11. Steuerbarer Bragg-Reflektor (100) nach einem der vorherigen Ansprüche, wobei die zweite Elektrode (140) sich über die Unterseite eines Übergitters erstreckt.

12. Steuerbarer Bragg-Reflektor (100) nach einem der vorherigen Ansprüche, wobei die äußeren Schichten eines Übergitters (110) jeweils eine Aluminiumnitridschicht (111) ist.

13. Steuerbarer Bragg-Reflektor-Stapel umfassend mindestens zwei seriell hintereinander geschaltete Bragg-Reflektoren (100) nach einem der Ansprüche 1-12, wobei diese unabhängig voneinander ansteuerbar sein können.

14. Steuerbare Bragg-Reflektor-Zeile bzw. Bragg-Reflektor-Matrix aus nebeneinander angeordneten und unabhängig voneinander ansteuerbaren Bragg-Reflektoren (100) nach einem der Ansprüche 1-12.

15. Verfahren zur Steuerung einer Reflektivität eines Bragg-Reflektors (100), wobei der Bragg-Reflektor

- mindestens eine Schicht eines Übergitters (110) aufweist, wobei das Übergitter (110) mindestens eine Schicht aus einem ersten Gruppe-3-Nitrid (111) und mindestens eine zweite Schicht aus einem zweiten Gruppe-3-Nitrid (112) aufweist und sich an der mindestens einen Grenzfläche innerhalb des Übergitters (110) Elektronen- oder Löchergase ausbilden,
- mindestens eine Schicht eines Halbleitermaterials (120) und
- zwei Elektroden (130, 140) aufweist, von denen mindestens eine Elektrode (130) lichtdurchlässig für einfallendes Licht ist und so angeordnet ist, dass das einfallende Licht (150) wenigstens teilweise durch die lichtdurchlässige Elektrode einfällt, und wobei die mindestens eine Schicht eines Übergitters (110) zwischen besagten Elektroden (130, 140) angeordnet ist, und das Verfahren mindestens den Schritt umfasst:
- Anlegen einer Spannung zwischen die beiden Elektroden (130, 140) zur Steuerung der Ladungsträgerdichte in mindestens einer Schicht des Übergitters.

16. Verfahren zur Steuerung einer Reflektivität eines Bragg-Reflektors (100) nach Anspruch 15, wobei die angelegte Spannung ($U$) im Bereich zwischen -10 V bis +10 V liegt.

17. Verfahren nach einem Ansprüche 15-16, wobei das erste Gruppe-3-Nitrid (111) Aluminiumnitrid (*AlN*) und das zweite Gruppe-3-Nitrid (112) Galliumnitrid (*GaN*) ist.

18. Verfahren nach einem der Ansprüche 15-17, wobei das Halbleitermaterial (120) Galliumnitrid (*GaN*) ist.

19. Verfahren nach einem der Ansprüche 15-18, wobei die mindestens eine transparente Elektrode (130) auf der Oberfläche der obersten Schicht des Bragg-Reflektors (100) angeordnet ist.

20. Verfahren nach einem der Ansprüche 15-19, wobei die mindestens eine transparente Elektrode (130) auf der Unterseite der untersten Schicht des Bragg-Reflektors (100) angeordnet ist.

21. Verfahren nach einem der Ansprüche 15-20, wobei die mindestens eine transparente Elektrode (130) zwischen zwei Schichten des Übergitters des Bragg-Reflektors (100) angeordnet ist.

22. Verfahren nach einem der Ansprüche 15-21, wobei das einfallende Licht (150) ausschließlich durch die mindestens eine transparente Elektrode (130) einfällt.

23. Verfahren nach einem der Ansprüche 15-22, wobei die erste Elektrode (130) ein leitendes Oxid, ein leitendes Polymer, ein semitransparenter Metallfilm oder ein hochdotierter p- oder n-Halbleiter ist und wobei die zweite Elektrode (140) ein leitendes Oxid, ein leitendes Polymer, ein Metallfilm oder ein hochdotierter p- oder n-Halbleiter ist.

24. Verfahren nach einem der Ansprüche 15-23, wobei die erste Elektrode (130) aus einem nicht-transparenten Material gebildet ist und eine Struktur aufweist, die zumindest teilweisen Lichteinfall in die Halbleiter- und Übergitterschichten zulässt.

25. Verfahren nach einem der Ansprüche 15-24, wobei die erste Elektrode (130) sich über die Oberseite des Übergitters erstreckt.

26. Verfahren nach einem der Ansprüche 15-25, wobei die zweite Elektrode (140) sich über die Unterseite eines Übergitters erstreckt.

27. Verfahren nach einem der Ansprüche 15-26, wobei die äußeren Schichten eines Übergitters (110) jeweils Aluminiumnitridschichten (111) sind.

28. Verfahren nach einem der Ansprüche 15-27, wobei mindestens zwei seriell hintereinander geschaltete Bragg-Reflektoren (100) durch Anlegen der Spannung gesteuert werden, wobei besagte Bragg-Reflektoren (100) unabhängig voneinander ansteuerbar sind.

**Claims**

1. Controllable Bragg reflector (100) for reflecting incident light (150), comprising:

   - at least one layer of a superlattice (110), wherein the superlattice (110) comprises at least one layer of a first group 3 nitride (111) and at least a second layer of a second group 3 nitride (112), wherein two-dimensional electron or hole gases develop at at least one interface within the superlattice (110),
   - at least one layer of semiconductor material (120) and
   - at least two electrodes (130, 140), wherein at least one electrode (130) is transparent to the incident light and the incident light (150) is incident at least partially through the at least one electrode (130), and wherein the at least one layer of a superlattice (110) is arranged between said electrodes (130, 140) and a voltage ($U$) can be applied between said electrodes (130, 140).

2. Controllable Bragg reflector 100 according to claim 1, wherein the first group 3 nitride (111) is aluminum nitride (*AlN*) and the second group 3 nitride (112) is gallium nitride (*GaN*).

3. Controllable Bragg reflector (100) according to either of the preceding claims, wherein the semiconductor material (120) is gallium nitride (*GaN*).

4. Controllable Bragg reflector (100) according to any of the preceding claims, wherein the at least one transparent electrode (130) is arranged on the surface of the uppermost layer of the Bragg reflector (100).

5. Controllable Bragg reflector (100) according to any of the preceding claims, wherein the at least one transparent electrode (130) is arranged on the underside of the lowermost layer of the Bragg reflector (100).

6. Controllable Bragg reflector (100) according to any of the preceding claims, wherein the at least one transparent electrode (130) is arranged between two layers of the superlattice of the Bragg reflector (100).

7. Controllable Bragg reflector (100) according to any of the preceding claims, wherein the incident light (150) is incident exclusively through the at least one transparent electrode (130).

8. Controllable Bragg reflector (100) according to any of the preceding claims, wherein the first electrode (130) is a conductive oxide, a conductive polymer, a semitransparent metal film, or a heavily doped p- or n-type semiconductor, and wherein the second electrode (140) is a conductive oxide, a conductive polymer, a metal film, or a heavily doped p- or n-type semiconductor.

9. Controllable Bragg reflector (100) according to any of the preceding claims, wherein the first electrode (130) is formed of a non-transparent material and has a structure that allows at least partial light incidence into the semiconductor layers and superlattice layers.

10. Controllable Bragg reflector (100) according to any of the preceding claims, wherein the first electrode (130) extends over the upper face of the superlattice.

11. Controllable Bragg reflector (100) according to any of the preceding claims, wherein the second electrode (140) extends over the underside of a superlattice.

12. Controllable Bragg reflector (100) according to any of the preceding claims, wherein each of the outer layers of a superlattice (110) is an aluminum nitride layer (111).

13. Controllable Bragg reflector stack comprising at least two Bragg reflectors (100) according to any of claims 1-12 connected in series one behind the other, wherein said reflectors can be controlled independently of one another.

14. Controllable Bragg reflector line or Bragg reflector matrix consisting of Bragg reflectors (100) according to any of claims 1-12 which are arranged next to one another and can be controlled independently of one another.

15. Method for controlling a reflectivity of a Bragg reflector (100), wherein the Bragg reflector

   - has at least one layer of a superlattice (110), wherein the superlattice (110) has at least one layer of a first group 3 nitride (111) and at least a second layer of a second group 3 nitride (112) and electron or hole gases develop at the at least one interface within the superlattice (110),

- at least one layer of semiconductor material (120) and

- two electrodes (130, 140), of which at least one electrode (130) is transparent to incident light and arranged such that the incident light (150) is incident at least partially through the transparent electrode, and wherein the at least one layer of a superlattice (110) is arranged between said electrodes (130, 140), and

the method comprises at least the step of:

- applying a voltage between the two electrodes (130, 140) to control the charge carrier density in at least one layer of the superlattice.

16. Method for controlling a reflectivity of a Bragg reflector (100) according to claim 15, wherein the applied voltage (*U*) is in the range between -10 V and +10 V.

17. Method according to any of claims 15-16, wherein the first group 3 nitride (111) is aluminum nitride (*AlN*) and the second group 3 nitride (112) is gallium nitride (*GaN*).

18. Method according to any of claims 15-17, wherein the semiconductor material (120) is gallium nitride (*GaN*).

19. Method according to any of claims 15-18, wherein the at least one transparent electrode (130) is arranged on the surface of the uppermost layer of the Bragg reflector (100).

20. Method according to any of claims 15-19, wherein the at least one transparent electrode (130) is arranged on the underside of the lowermost layer of the Bragg reflector (100).

21. Method according to any of claims 15-20, wherein the at least one transparent electrode (130) is arranged between two layers of the superlattice of the Bragg reflector (100).

22. Method according to any of claims 15-21, wherein the incident light (150) is incident exclusively through the at least one transparent electrode (130).

23. Method according to any of claims 15-22, wherein the first electrode (130) is a conductive oxide, a conductive polymer, a semitransparent metal film, or a heavily doped p- or n-type semiconductor, and wherein the second electrode (140) is a conductive oxide, a conductive polymer, a metal film, or a heavily doped p- or n-semiconductor.

24. Method according to any of claims 15-23, wherein the first electrode (130) is formed of a non-transparent material and has a structure that allows at least partial incidence of light into the semiconductor and superlattice layers.

25. Method according to any of claims 15-24, wherein the first electrode (130) extends over the upper face of the superlattice.

26. Method according to any of claims 15-25, wherein the second electrode (140) extends over the underside of a superlattice.

27. Method according to any of claims 15-26, wherein the outer layers of a superlattice (110) are each aluminum nitride layers (111).

28. Method according to any of claims 15-27, wherein at least two Bragg reflectors (100) connected in series one behind the other are controlled by applying the voltage, wherein said Bragg reflectors (100) can be controlled independently of one another.


**Revendications**

1. Réflecteur de Bragg commandable (100) permettant de réfléchir une lumière incidente (150), comprenant :

   - au moins une couche d'un super-réseau (110), ledit super-réseau (110) comprenant au moins une couche constituée d'un premier nitrure de groupe III (111) et au moins une seconde couche constituée d'un second nitrure de groupe III (112), des gaz bidimensionnels d'électrons ou de trous étant formés au niveau d'au moins une surface limite à l'intérieur du super-réseau (110),
   - au moins une couche d'un matériau semi-conducteur (120) et
   - au moins deux électrodes (130, 140), au moins une électrode (130) laissant passer la lumière incidente et la lumière incidente (150) étant au moins partiellement incidente à travers l'au moins une électrode (130), et l'au moins une couche d'un super-réseau (110) étant disposée entre lesdites électrodes (130, 140) et une tension (U) pouvant être appliquée entre lesdites électrodes (130, 140).

2. Réflecteur de Bragg commandable (100) selon la revendication 1, dans lequel le premier nitrure de groupe III (111) est du nitrure d'aluminium (*AlN*) et le second nitrure de groupe III (112) est du nitrure de gallium (*GaN*).

3. Réflecteur de Bragg commandable (100) selon l'une des revendications précédentes, dans lequel le matériau semi-conducteur (120) est du nitrure de gallium (*GaN*).

4. Réflecteur de Bragg commandable (100) selon l'une des revendications précédentes, dans lequel l'au moins une électrode transparente (130) est disposée sur la surface de la couche supérieure du réflecteur de Bragg (100).

5. Réflecteur de Bragg commandable (100) selon l'une des revendications précédentes, dans lequel l'au moins une électrode transparente (130) est disposée sur la face inférieure de la couche inférieure du réflecteur de Bragg (100).

6. Réflecteur de Bragg commandable (100) selon l'une des revendications précédentes, dans lequel l'au moins une électrode transparente (130) est disposée entre deux couches du super-réseau du réflecteur de Bragg (100).

7. Réflecteur de Bragg commandable (100) selon l'une des revendications précédentes, dans lequel la lumière incidente (150) est incidente uniquement à travers l'au moins une électrode transparente (130).

8. Réflecteur de Bragg commandable (100) selon l'une des revendications précédentes, dans lequel la première électrode (130) est un oxyde conducteur, un polymère conducteur, un film métallique semi-transparent ou un semi-conducteur de type p ou n fortement dopé et dans lequel la seconde électrode (140) est un oxyde conducteur, un polymère conducteur, un film métallique ou un semi-conducteur de type p ou n fortement dopé.

9. Réflecteur de Bragg commandable (100) selon l'une des revendications précédentes, dans lequel la première électrode (130) est formée d'un matériau non transparent et présente une structure qui permet au moins en partie une entrée de lumière dans les couches de semi-conducteur et de super-réseau.

10. Réflecteur de Bragg commandable (100) selon l'une des revendications précédentes, dans lequel la première électrode (130) s'étend à travers la face supérieure du super-réseau.

11. Réflecteur de Bragg commandable (100) selon l'une des revendications précédentes, dans lequel la seconde électrode (140) s'étend à travers la face inférieure d'un super-réseau.

12. Réflecteur de Bragg commandable (100) selon l'une des revendications précédentes, dans lequel les couches externes d'un super-réseau (110) sont respectivement des couches de nitrure d'aluminium (111).

13. Empilement de réflecteurs de Bragg commandable comprenant au moins deux réflecteurs de Bragg (100) selon l'une des revendications 1 à 12 connectés en série l'un derrière l'autre, lesdits réflecteurs de Bragg commandables pouvant être commandés indépendamment l'un de l'autre.

14. Ligne de réflecteurs de Bragg ou matrice de réflecteurs de Bragg commandable constituée de réflecteurs de Bragg (100) selon l'une des revendications 1 à 12 disposés les uns à côté des autres et commandables indépendamment les uns des autres.

15. Procédé permettant de commander la réflectivité d'un réflecteur de Bragg (100), le réflecteur de Bragg

- présentant au moins une couche d'un super-réseau (110), le super-réseau (110) présentant au moins une couche constituée d'un premier nitrure de groupe III (111) et au moins une seconde couche constituée d'un second nitrure de groupe III (112) et des gaz d'électrons ou de trous étant formés au niveau de l'au moins une surface limite à l'intérieur du super-réseau (110),
- présentant au moins une couche d'un matériau semi-conducteur (120) et
- deux électrodes (130, 140), parmi lesquelles au moins une électrode (130) laisse passer une lumière incidente et est disposée de telle sorte que la lumière incidente (150) est au moins partiellement incidente à travers l'électrode laisser passer la lumière, et l'au moins une couche d'un super-réseau (110) étant disposée entre lesdites électrodes (130, 140), et

le procédé comprenant au moins l'étape :

- d'application d'une tension entre les deux électrodes (130, 140) pour commander la densité de porteurs de charge dans au moins une couche du super-réseau.

16. Procédé permettant de commander la réflectivité d'un réflecteur de Bragg (100) selon la revendication 15, dans lequel la tension (*U*) appliquée se situe dans une plage comprise entre -10 V et +10 V.

17. Procédé selon l'une des revendications 15 et 16, dans lequel le premier nitrure de groupe III (111) est du nitrure d'aluminium (*AlN*) et le second nitrure de groupe III (112) est du nitrure de gallium (*GaN*).

18. Procédé selon l'une des revendications 15 à 17, dans lequel le matériau semi-conducteur (120) est du nitrure de gallium (*GaN*).

19. Procédé selon l'une des revendications 15 à 18, dans lequel l'au moins une électrode transparente (130) est disposée sur la surface de la couche supérieure du réflecteur de Bragg (100).

20. Procédé selon l'une des revendications 15 à 19, dans lequel l'au moins une électrode transparente (130) est disposée sur la face inférieure de la couche inférieure du réflecteur de Bragg (100).

21. Procédé selon l'une des revendications 15 à 20, dans lequel l'au moins une électrode transparente (130) est disposée entre deux couches du super-réseau du réflecteur de Bragg (100).

22. Procédé selon l'une des revendications 15 à 21, dans lequel la lumière incidente (150) est incidente uniquement à travers l'au moins une électrode transparente (130).

23. Procédé selon l'une des revendications 15 à 22, dans lequel la première électrode (130) est un oxyde conducteur, un polymère conducteur, un film métallique semi-transparent ou un semi-conducteur de type p ou n fortement dopé et dans lequel la seconde électrode (140) est un oxyde conducteur, un polymère conducteur, un film métallique ou un semi-conducteur de type p ou n fortement dopé.

24. Procédé selon l'une des revendications 15 à 23, dans lequel la première électrode (130) est formée d'un matériau non transparent et présente une structure qui permet au moins en partie une entrée de lumière dans les couches de semi-conducteur et de super-réseau.

25. Procédé selon l'une des revendications 15 à 24, dans lequel la première électrode (130) s'étend à travers la face supérieure du super-réseau.

26. Procédé selon l'une des revendications 15 à 25, dans lequel la seconde électrode (140) s'étend à travers la face inférieure d'un super-réseau.

27. Procédé selon l'une des revendications 15 à 26, dans lequel les couches externes d'un super-réseau (110) sont respectivement des couches de nitrure d'aluminium (111).

28. Procédé selon l'une des revendications 15 à 27, dans lequel au moins deux réflecteurs de Bragg (100) connectés en série l'un derrière l'autre sont commandés par application de tension, lesdits réflecteurs de Bragg (100) pouvant être commandés indépendamment l'un de l'autre.

Fig. 1

Fig. 2

**EP 3 295 245 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20070291808 A1
- US 20090041464 A

**In der Beschreibung aufgeführte Nicht-Patentliteratur**

- **ADA WILLE.** Strain relief mechanisms and growth behaviour of superlattice distributed Bragg reflectors. *Physica Status Solidi C: Current Topics in Solid State Physics,* 2014, vol. 11, 758-761
- **YAN-KUIN SU et al.** A novel vertical-cavity surface-emitting laser with semiconductor/superlattice distributed bragg reflectors. *IEEE Photonics Technology Letters,* 2002, vol. 14 (10), 1388-1390